# EUROPÄISCHE PATENTSCHRIFT

(11) **EP 2 901 552 B1**
(45) Veröffentlichungstag und Bekanntmachung des Hinweises auf die Patenterteilung: **16.10.2019**
(21) Anmeldenummer: 13728197.8
(22) Anmeldetag: 12.06.2013
(51) Int. Cl.: H03K 5/151, H03K 5/1252

(54) **LOGISCHES GATTER ZUR SYMMETRIERUNG MINDESTENS ZWEIER EINGANGSSIGNALE SOWIE EIN LOGISCHES GATTERSYSTEM**
LOGIC GATE FOR THE SYMMETRIZATION OF AT LEAST TWO INPUT SIGNALS AND A LOGIC GATE SYSTEM
PORTE LOGIQUE POUR RENDRE SYMÉTRIQUE AU MOINS DEUX SIGNAUX D'ENTRÉE AINSI QUE SYSTÈME DE PORTES LOGIQUES

(30) Priorität: 28.09.2012 DE 102012217816
(43) Veröffentlichungstag der Anmeldung: 05.08.2015
(73) Patentinhaber: Robert Bosch GmbH, 70442 Stuttgart (DE)
(72) Erfinder: EITRICH, Frank-Thomas, 72760 Reutlingen (DE)
(86) Internationale Anmeldenummer: PCT/EP2013/062147
(87) Internationale Veröffentlichungsnummer: WO 2014/048592

(56) Entgegenhaltungen:
- JP-A- H02 101 819
- JP-A- 2002 135 092
- US-A- 4 110 698
- US-A1- 2007 216 446
- US-B1- 6 222 422
- KVINGE T: "TRANSMISSION GATE IMPROVES CLOCK DRIVER", EDN ELECTRICAL DESIGN NEWS.(TEXAS INSTRUMENT), REED BUSINESS INFORMATION, HIGHLANDS RANCH, CO, US, Bd. 32, Nr. 23, 12. November 1987 (1987-11-12), Seite 287, XP002055261, ISSN: 0012-7515

## Beschreibung

Die vorliegende Erfindung betrifft ein logisches Gatter zur Symmetrierung mindestens zweier Eingangssignale sowie ein logisches Gattersystem, welches mindestens zwei erfindungsgemäße logische Gatter umfasst.

### Stand der Technik

Analoge Anwendungen werden mit zunehmender Häufigkeit digital gesteuert. Beispielsweise werden bei der Switched Capacitor Technik Analog-Schaltmittel digital angesteuert. In der CMOS- (Complementary Metal-Oxide Semiconductor) Technik sind solche Analog-Schaltmittel sowie alle digitalen Gatter durch komplementäre Transistoren realisiert. Aus technologischen beziehungsweise fertigungstechnischen Gründen können die erwähnten Transistoren nur innerhalb von Toleranzen annähernd komplementär realisiert werden.

Zur Ansteuerung der angenähert komplementären Transistoren werden komplementäre Schaltsignale, die ein Signal-Paar bilden, verwendet. Die digitalen Werte der Schaltsignale eines Signal-Paares sind dabei invers zueinander. Die Erzeugung zweier solcher zueinander inverser Schaltsignale ist auch bei Verwendung schneller Transistoren nicht unter Ausschluss von Verzögerungen möglich, die sich als Laufzeit-Differenz der beiden komplementären Signal-Flanken der Schaltsignale zeigt. Bei steigenden Genauigkeits-Anforderungen ist es jedoch notwendig, die nur angenähert direkt zueinander komplementären Schaltsignale eines Signal-Paares zu symmetrisieren, sodass im Optimum die High-Flanke des ersten Schaltsignals eines Signal-Paares synchron mit der komplementären Low-Flanke des zweiten Schaltsignals des Signal-Paares und umgekehrt erscheinen. Im Stand der Technik erfolgt eine solche Symmetrierung meist unter Durchführung einer Transistor-Treiberstärken-Anpassung. Dabei werden die Laufzeiten der Schaltsignale eines Signal-Paares durch die Verzögerung des ersten oder zweiten Schaltsignals aufeinander abgestimmt. Eine solche Verzögerung eines Schaltsignals kann beispielsweise über die Verwendung von Transfer-Gates oder Transmission-Gates realisiert werden. Eine weitere Symmetrierungs-Technik basiert auf der Verschaltung mindestens zweier Inverter zu einem Ring.

Aufgrund der bereits erwähnten Technologie- und Fertigungsstreuung bilden die oben beschriebenen statistischen Maßnahmen, die zunächst nur durch eine Simulation und dann durch eine Design-Zentrierung umgesetzt werden, keine fertigungsstabile Lösung zur Symmetrierung von Schaltsignalen. Umgekehrt können solche Maßnahmen sogar dazu beitragen, die Genauigkeit von beispielsweise Analog/Digital-Wandlern, Digital/Analog-Wandlern oder geschalteten Komparatoren zu verringern. Ferner bedingen die oben vorgestellten Maßnahmen des Standes der Technik eine signifikante Erhöhung des Energieverbrauchs. Des Weiteren können bei einigen der oben vorgestellten Maßnahmen Stromspitzen entstehen, die für andere Teile der Schaltung, insbesondere bei hohen Genauigkeits-Anforderungen, störend sein können.

In der JP 2002135092 A wird ein Schaltkreis mit einem Inverter, dessen Ausgang mit einem p-Kanal-Transistor verbunden ist, sowie einer Energiequelle, einem Output Terminal und einem n-Kanal-Transistor offenbart, welcher zwei mit zu symmetrisierenden analogen Eingangssignalen beaufschlagbare Eingänge aufweist, welche jeweils mit einem Anpassungsschaltkreis sowie einem weiteren Schaltkreis elektrisch leitfähig verbunden sind. Der Schaltkreis dient der Symmetrisierung der beiden Eingangssignale.

Ferner offenbart die US 2004/0081246 A1 eine Vorrichtung mit einem Eingang zur Beaufschlagung mit einem differenziellen Signalpaar, welches eine erstes und ein zweites Signal umfasst. Des Weiteren weist die Vorrichtung eine Repeater-Schaltung zur Wiederauffrischung des ersten und zweiten Signals und zur Erzeugung eines ersten Ausgangssignals auf, welches im Wesentlichen invers zu einem durch die Repeater-Schaltung erzeugbaren zweiten Ausgangssignal ist.

In der JP H02 101819 A wird eine Realisierung eines ODER- und eines UND-Gatters mit einem invertierenden und einem nicht-invertierenden Eingang mit jeweils zwei Transistoren offenbart.

### Offenbarung der Erfindung

Erfindungsgemäß wird ein logisches Gatter zur Symmetrierung mindestens zweier Eingangssignale bereitgestellt, welches einen nicht-invertierenden Eingang, einen invertierenden Eingang und einen Ausgang umfasst. Der am Ausgang anliegende Wert entspricht dem Inversen des am invertierenden Eingang anliegenden Wertes. Der Ausgang wird ausschließlich dann aktiviert, wenn der am nicht-invertierenden Eingang anliegende Wert ebenfalls dem Inversen des am invertierenden Eingang anliegenden Wertes entspricht. In einem nicht aktivierten Zustand nimmt der Ausgang einen hochohmigen, nicht leitenden Zustand an. In einem aktivierten Zustand hängt der am Ausgang anliegende Ausgangswert von den an dem nicht-invertierenden Eingang und von den an dem invertierenden Eingang anliegenden Werten der Eingangssignale ab. Ferner weist das logische Gatter ein UND-Gatter mit einem invertierenden und einem nicht-invertierenden Eingang und ein ODER-Gatter mit einem invertierenden und einem nicht-invertierenden Eingang auf, wobei die nicht-invertierenden Eingänge von UND-Gatter und ODER-Gatter mit dem invertierenden Eingang des logischen Gatters verbunden sind, während die invertierenden Eingänge von UND-Gatter und ODER-Gatter mit dem nicht-invertierenden Eingang des logischen Gatters verbunden sind. Erfindungsgemäß sind das UND-Gatter sowie das ODER-Gatter durch jeweils zwei zueinander komplementäre Transistoren realisiert, wobei die Gate-Anschlüsse der das UND-Gatter bildenden Transistoren miteinander zu dem invertierenden Eingang des UND-Gatters verbunden sind und wobei die Gate-Anschlüsse der das ODER-Gatter bildenden Transistoren miteinander zu dem invertierenden Eingang des ODER-Gatters verbunden sind.

Durch die Verwendung eines derartigen logischen Gatters kann eine Symmetrierung zweier Schaltsignale herbeigeführt werden, da der Ausgang des logischen Gatters erst bei Vorliegen zueinander inverser Signale durchschaltet. Solange die beiden an den Eingängen des logischen Gatters anliegenden Schaltsignale logisch identisch sind, verbleibt der Ausgang des logischen Gatters hochohmig und passiv. Des Weiteren beansprucht das logische Gatter nur sehr wenig Bauraum und ist, auch da es beispielsweise lediglich unter Verwendung von Standard-CMOS-Transistoren realisierbar ist, gut simulierbar und kostengünstig. Da das UND-Gatter sowie das ODER-Gatter als Spar-UNDbeziehungsweise als Spar-ODER-Gatter ausgeführt sind, erfolgt die Invertierung der an den invertierenden Eingängen von UND- sowie ODER-Gatter anliegenden Eingangssignale zeitverlustfrei.

Vorzugsweise sind der Ausgang des UND-Gatters mit der Steuerelektrode eines ersten Transistors und der Ausgang des ODER-Gatters mit der Steuerelektrode eines zweiten Transistors verbunden. Bei einer solchen Ausführung des logischen Gatters kann selbiges durch die Skalierung der Dimension der Transistoren sowie der Skalierung der Verstärkungsfaktoren der Transistoren genau auf eine Lastanforderung abgestimmt werden.

In einer bevorzugten Ausführungsform ist die Schaltstrecke des ersten Transistors mit der Schaltstrecke des zweiten Transistors in Reihe geschaltet.

Bevorzugt ist die elektrische Verbindung zwischen der Schaltstrecke des ersten Transistors und der Schaltstrecke des zweiten Transistors mit dem Ausgang des logischen Gatters elektrisch verbunden.

In einer bevorzugten Ausführungsform sind der zweite Transistor als P-Kanal-MOSFET und der erste Transistor als N-Kanal-MOSFET ausgeführt. MOSFETS sind kostengünstig und sehr kompakt, das heißt, in einer hohen Integrationsdichte realisierbar. Ferner weisen MOSFETS eine schnelle Schaltzeit sowie stabile Verstärkungs- und Antwortzeiten auf.

Ferner ist es bevorzugt, sowohl das UND-Gatter als auch das ODER-Gatter unter Verwendung jeweils eines N-Kanal-MOSFETS und jeweils eines P-Kanal-MOSFETS zu realisieren.

Bevorzugt ist der Source-Anschluss des zweiten Transistors mit einem konstanten Potenzial verbunden. Besonders bevorzugt entspricht das konstante Potenzial der lokalen Masse des logischen Gatters.

Ferner wird ein logisches Gattersystem bereitgestellt, welches mindestens zwei erfindungsgemäße logische Gatter umfasst, wobei der nicht-invertierende

Eingang des zweiten logischen Gatters mit dem invertierenden Eingang des ersten logischen Gatters verbunden ist, während der invertierende Eingang des zweiten logischen Gatters mit dem nicht-invertierenden Eingang des ersten logischen Gatters verbunden ist. Durch die paarweise Verwendung der logischen Gatter können zwei Schaltsignale auf vorteilhafte Weise symmetrisiert werden.

Es ist bevorzugt, logische Gattersysteme mit mehr als zwei, beispielsweise sechs erfindungsgemäßen logischen Gattern zu realisieren, wobei jeweils zwei logische Gatter, wie vorhergehend beschrieben, zu jeweils einem Paar zusammengeschaltet sind, wobei die Paare aus jeweils zwei erfindungsgemäßen logischen Gattern innerhalb des logischen Gattersystems hintereinander geschaltet sind. Über eine solche Serienschaltung von Paaren aus erfindungsgemäßen logischen Gattern lassen sich sehr genaue Symmetrierungen erreichen.

Bevorzugt umfasst das logische Gattersystem ferner ein Nicht-Gatter, wobei der Eingang des Nicht-Gatters mit dem nicht-invertierenden Eingang des ersten logischen Gatters verbunden ist, während der Ausgang des Nicht-Gatters mit dem nicht-invertierenden Eingang des zweiten logischen Gatters verbunden ist.

Vorzugsweise umfasst das logische Gattersystem in einer bevorzugten Weiterentwicklung der vorletzten Ausführungsform ferner ein Nicht-Gatter, wobei der Eingang des Nicht-Gatters mit dem invertierenden Eingang des ersten logischen Gatters verbunden ist, während der Ausgang des Nicht-Gatters mit dem invertierenden Eingang des zweiten logischen Gatters verbunden ist. Nicht-Gatter, vor die Eingänge beispielsweise eines teureren Bauteils geschaltet, können unter anderem dazu dienen, das teurere Bauteil vor versehentlich auftretenden Überspannungen zu schützen. Des Weiteren sind Nicht-Gatter sehr preiswert.

In einer bevorzugten Weiterentwicklung dieser Ausführungsform umfasst das logische Gattersystem ferner ein erstes und ein zweites weiteres Nicht-Gatter, welche in die elektrische Verbindung zwischen dem nicht-invertierenden Eingang des ersten logischen Gatters und dem Eingang des Nicht-Gatters geschaltet sind, wobei der Ausgang des ersten weiteren Nicht-Gatters mit dem Eingang des zweiten weiteren Nicht-Gatters verbunden ist, wobei der Ausgang des zweiten weiteren Nicht-Gatters mit dem nicht-invertierenden Eingang des ersten logischen Gatters verbunden ist, während der Eingang des ersten weiteren Nicht-Gatters mit dem Eingang des Nicht-Gatters verbunden ist. Durch die Hintereinanderschaltung zweier Nicht-Gatter kann eine Signalverstärkung des die Nicht-Gatter durchlaufenden Signals erreicht werden.

Vorzugsweise ist der Eingang des ersten weiteren Nicht-Gatters mit einer Eingangs-Schutzeinheit verbunden, welche dazu ausgebildet ist, das logische Gattersystem vor einer elektrostatischen Aufladung zu schützen.

Bevorzugt ist die elektrische Verbindung zwischen dem nicht-invertierenden Eingang des ersten logischen Gatters und dem invertierenden Eingang des zweiten logischen Gatters mit der ersten Elektrode eines Kondensators verbunden, dessen zweite Elektrode mit der elektrischen Verbindung zwischen dem Eingang des ersten weiteren Nicht-Gatters und dem Eingang des Nicht-Gatters verbunden ist. Ein solcher Kondensator dient der Kompensation von Schaltflanken-Überschwingern der an den Eingängen des logischen Gattersystems anliegenden Schaltsignale.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Ausführungsbeispiel eines erfindungsgemäßen logischen Gatters mit zugehöriger Wertetabelle,
Figur 2 ein Ausführungsbeispiel eines erfindungsgemäßen logischen Gatters mit UND-Gatter und ODER-Gatter,
Figur 3 ein Ausführungsbeispiel eines erfindungsgemäßen logischen Gatters mit Spar-UND-Gatter sowie Spar-ODER-Gatter,
Figur 4 ein Ausführungsbeispiel eines erfindungsgemäßen logischen Gattersystems mit zwei erfindungsgemäßen logischen Gattern, und
Figur 5 ein spezielles Ausführungsbeispiel eines erfindungsgemäßen logischen Gattersystems.

### Ausführungsformen der Erfindung

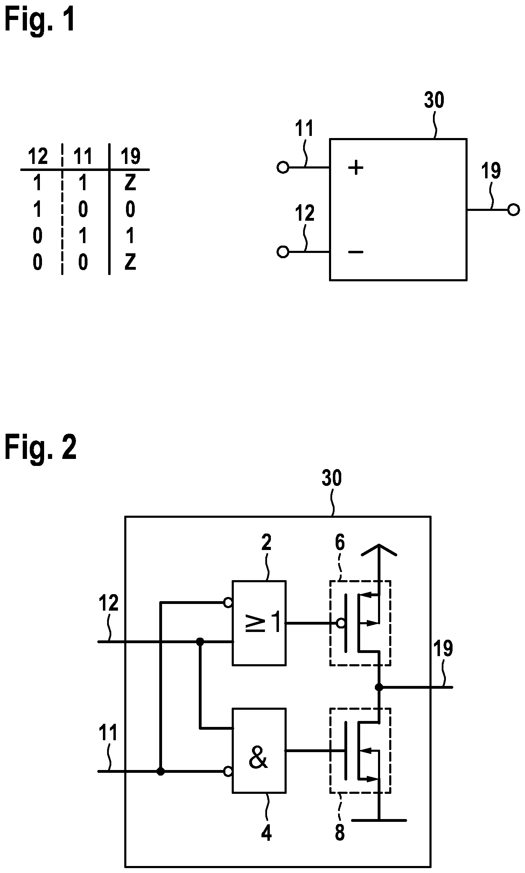

In der Figur 1 ist ein Ausführungsbeispiel eines erfindungsgemäßen logischen Gatters 30 mit zugehöriger Wertetabelle dargestellt. Das logische Gatter 30 weist einen nicht-invertierenden Eingang 11 zur Beaufschlagung mit einem ersten Schaltsignal und einen invertierenden Eingang 12 zur Beaufschlagung mit einem zweiten Schaltsignal auf. Des Weiteren weist das logische Gatter 30 einen Ausgang 19 auf. Der an dem Ausgang 19 anliegende Wert entspricht stets dem Inversen beziehungsweise dem Komplementären des an dem invertierenden Eingang 12 anliegenden Wertes. Allerdings wird der Ausgang 19 ausschließlich dann aktiviert beziehungsweise niederohmig, also leitend geschaltet, wenn der am nicht-invertierenden Eingang 11 anliegende Wert ebenfalls dem Inversen beziehungsweise dem Komplementären des am invertierenden Eingang 12 anliegenden Wertes entspricht, also zu dem am invertierenden Eingang 12 anliegenden Wert komplementär ist. Sind die Schaltsignale, die am invertierenden Eingang 12 und am nicht-invertierenden Eingang 11 anliegen, logisch identisch, verbleibt der Ausgang 19 in einem passiven, hochohmigen Zustand.

Die in Figur 1 gezeigte Wertetabelle zeigt das Schaltverhalten des erfindungsgemäßen logischen Gatters 30 für Eingangswerte 1 und 0, welche die Schaltsignale aufweisen, mit denen der nicht-invertierende Eingang 11 und der invertierende Eingang 12 beaufschlagt werden können. Je nachdem, welche Werte die Schaltsignale am invertierenden Eingang 12 und am nicht-invertierenden Eingang 11 aufweisen beziehungsweise annehmen, ergibt sich ein Ausgangswert beziehungsweise ein Ausgangssignal am Ausgang 19 des logischen Gatters 30. Sind die Werte der Schaltsignale am nicht-invertierenden Eingang 11 und am invertierenden Eingang 12 identisch, so nimmt der Ausgang 19 des logischen Gatters 30 einen hochohmigen, also nicht leitenden Zustand Z an. Dies ist in den Zeilen eins und vier der Wertetabelle dargestellt. Sind die Werte der Schaltsignale am nicht-invertierenden Eingang 11 und am invertierenden Eingang 12 komplementär, also invers, zueinander, dann entspricht der Wert am Ausgang 19 des logischen Gatters 30 beziehungsweise der Wert des Ausgangssignals am Ausgang des logischen Gatters 30 dem instantan gegebenen Wert desjenigen Schaltsignals, mit welchem der nicht-invertierende Eingang 11 beaufschlagt wird, beziehungsweise der Inverse desjenigen Schaltsignals, mit welchem der invertierende Eingang 12 des logischen Gatters 30 beaufschlagt wird. Dies ist in den Zeilen zwei und drei der Wertetabelle dargestellt.

Die Figur 2 zeigt ein Ausführungsbeispiel eines erfindungsgemäßen logischen Gatters 30 mit UND-Gatter 4 und ODER-Gatter 2. Das logische Gatter 30 weist in diesem Ausführungsbeispiel also ein UND-Gatter 4 mit einem invertierenden und einem nicht-invertierenden Eingang sowie ein ODER-Gatter 2 mit einem invertierenden und einem nicht-invertierenden Eingang auf. Sowohl der nicht-invertierende Eingang des UND-Gatters 4 als auch der nicht-invertierende Eingang des ODER-Gatters 2 sind mit dem invertierenden Eingang 12 des logischen Gatters 30 elektrisch leitend verbunden. Hingegen ist sowohl der invertierende Eingang des UND-Gatters 4 und der invertierende Eingang des ODER-Gatters 2 mit dem nicht-invertierenden Eingang 11 des logischen Gatters 30 elektrisch leitend verbunden. Der Ausgang des UND-Gatters 4 ist in diesem Ausführungsbeispiel mit der Steuerelektrode eines ersten Transistors 8 elektrisch leitend verbunden. Der Ausgang des ODER-Gatters 2 ist in diesem Ausführungsbeispiel mit der Steuerelektrode eines zweiten Transistors 6 elektrisch leitend verbunden. Dabei ist in diesem Ausführungsbeispiel die Schaltstrecke des ersten Transistors 8 mit der Schaltstrecke des zweiten Transistors 6 in Reihe geschaltet, das heißt, die beiden Schaltstrecken sind über eine elektrisch leitende Verbindung elektrisch leitend miteinander verbunden. Die elektrische Verbindung zwischen der Schaltstrecke des ersten Transistors 8 und der Schaltstrecke des zweiten Transistors 6 ist in diesem Ausführungsbeispiel eines erfindungsgemäßen logischen Gatters 30 mit dem Ausgang 19 des logischen Gatters 30 elektrisch leitend verbunden.

In dem Ausführungsbeispiel der Figur 2 ist der zweite Transistor 6 rein beispielhaft als P-Kanal-MOSFET und der erste Transistor 8 rein beispielhaft als N-Kanal-MOSFET ausgeführt. Dabei ist der Source-Anschluss des ersten Transistors 8 in diesem Ausführungsbeispiel rein beispielhaft mit einem konstanten Potenzial, in diesem Ausführungsbeispiel der lokalen Masse des logischen Gatters 30, elektrisch leitend verbunden. Der Source-Anschluss des zweiten Transistors 6 ist in diesem Ausführungsbeispiel rein beispielhaft mit einem weiteren Teil einer nicht dargestellten logischen Schaltung beziehungsweise einem anderen logischen Gatter verbunden. Der Drain-Anschluss des ersten Transistors 8 ist über eine elektrische Verbindung mit dem Drain-Anschluss des zweiten Transistors 6 elektrisch leitend verbunden. Diese elektrische Verbindung ist in diesem Ausführungsbeispiel identisch mit der die beiden Schaltstrecken der Transistoren 6, 8 verbindenden elektrisch leitenden Verbindung. Somit bilden der erste und der zweite Transistor 8, 6 einen logischen Inverter.

Für die Realisierung eines beispielhaften logischen Gatters 30 ist sowohl die Verwendung von einem UND-Gatter 4 als auch die Verwendung von einem ODER-Gatter 2 optional. Es können auch beispielhafte logische Gatter 30 ohne diese Komponenten oder aber auch mit anderen Gattern realisiert werden. Auch kann eine beispielhafte logische Schaltung 30 realisiert werden, welche keinen ersten und/oder keinen zweiten Transistor 8, 6 beziehungsweise gar keine Transistoren aufweist. Wird ein erfindungsgemäßes logisches Gatter 30 mit einem ersten und/oder einem zweiten Transistor 8, 6 realisiert, müssen diese auch nicht als MOSFET ausgeführt sein. Rein beispielhaft können sie auch als bipolare Transistoren oder als IGBT realisiert sein.

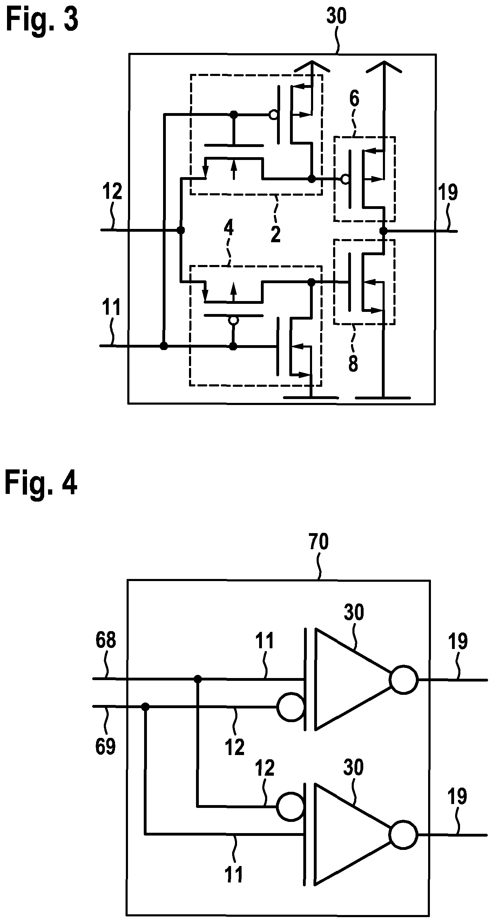

Die Figur 3 zeigt ein Ausführungsbeispiel eines erfindungsgemäßen logischen Gatters 30 mit Spar-UND-Gatter 4 sowie Spar-ODER-Gatter 2. Das in Figur 3 gezeigte Ausführungsbeispiel ist im Wesentlichen identisch mit dem in Figur 2 gezeigten Ausführungsbeispiel. Die gleich bezeichneten Komponenten in Figur 3 entsprechen jenen des Ausführungsbeispiels der Figur 2, sodass das dort Beschriebene bezüglich dieser Komponenten auch auf das Ausführungsbeispiel der Figur 3 zu übertragen ist. Die in Figur 2 und 3 gezeigten Ausführungsbeispiele unterscheiden sich darin, dass in dem in Figur 3 gezeigten Ausführungsbeispiel das UND-Gatter 4 sowie das ODER-Gatter 2 durch jeweils zwei zueinander komplementäre Transistoren realisiert sind. Das UND-Gatter 4 sowie das ODER-Gatter 2 sind in diesem Ausführungsbeispiel rein beispielhaft durch jeweils einen N-Kanal-MOSFET sowie jeweils einen P-Kanal-MOSFET gebildet. Dabei sind die Gate-Anschlüsse der das UND-Gatter 4 bildenden Transistoren miteinander zu dem invertierenden Eingang des UND-Gatters 4 verbunden. Die Gate-Anschlüsse der das ODER-Gatter 2 bildenden Transistoren sind miteinander zu dem invertierenden Eingang des ODER-Gatters 2 verbunden. Der Source-Anschluss des N-Kanal-MOSFETS des UND-Gatters 4 ist mit dem Source-Anschluss des P-Kanal-MOSFETS des ODER-Gatters 2 verbunden und bildet mit diesem zusammen den nicht-invertierenden Eingang des UND- sowie des ODER-Gatters 4, 2.

Bei einer derartigen Ausführungsform des erfindungsgemäßen logischen Gatters 30 ist also sowohl das UND-Gatter 4 als auch das ODER-Gatter 2, welche jeweils einen invertierenden beziehungsweise inversen Eingang aufweisen, als Spar-UND beziehungsweise Spar-ODER-Gatter 4, 2, also durch jeweils genau zwei komplementäre CMOS-Transistoren, realisiert. Dadurch wird erfindungsgemäß eine zeitverlustfreie Invertierung beziehungsweise Inversion des an dem invertierenden Eingang 12 des erfindungsgemäßen logischen Gatters 30 anliegenden Schaltsignals möglich, wobei für die Realisierung des UND-Gatters 4 sowie für die Realisierung des ODER-Gatters 2 jeweils nur zwei Transistoren benötigt werden.

Die Figur 4 zeigt ein Ausführungsbeispiel eines erfindungsgemäßen logischen Gattersystems 70 mit zwei erfindungsgemäßen logischen Gattern 30. In diesem Ausführungsbeispiel sind die beiden logischen Gatter 30 über an das Symbol des Nicht-Gatters angelehnte Symbole dargestellt. Das logische Gattersystem 70 hat in diesem Ausführungsbeispiel zwei Ausgänge, die durch die Ausgänge 19 der beiden logischen Gatter 30 gebildet werden. Ferner weist das logische Gattersystem 70 einen ersten Eingang 68 und einen zweiten Eingang 69 auf, wobei der erste Eingang 68 des logischen Gattersystems 70 mit dem nicht-invertierenden Eingang 11 des ersten logischen Gatters 30 verbunden ist, beziehungsweise von diesem gebildet wird, während der zweite Eingang 69 des logischen Gattersystems 70 mit dem invertierenden Eingang 12 des ersten logischen Gatters 30 verbunden ist, beziehungsweise von diesem gebildet wird.

In diesem Ausführungsbeispiel ist der nicht-invertierende Eingang 11 des zweiten logischen Gatters 30 mit dem invertierenden Eingang 12 des ersten logischen Gatters 30 verbunden, während der invertierende Eingang 12 des zweiten logischen Gatters 30 mit dem nicht-invertierenden Eingang 11 des ersten logischen Gatters 30 verbunden ist. Mit anderen Worten ausgedrückt, ist in diesem Ausführungsbeispiel des logischen Gatters 70 der nicht-invertierende Eingang 11 des zweiten logischen Gatters 30 mit dem zweiten Eingang 69 des logischen Gattersystems 70 verbunden, während der invertierende Eingang 12 des zweiten logischen Gatters 30 mit dem ersten Eingang 69 des logischen Gattersystems 70 verbunden ist.

Wird der erste Eingang 68 des logischen Gattersystems 70 mit dem ersten Schaltsignal eines Signalpaares beaufschlagt und der zweite Eingang 69 des logischen Gattersystems 70 mit dem anderen, komplementären Schaltsignal des Signalpaares beaufschlagt, werden diese Schaltsignale des Signal-Paares durch beide logischen Gatter 30 des logischen Gattersystems 70 synchronisiert. Dadurch sind mit den an den beiden Ausgängen 19 durch das erste und zweite logische Gatter 30 ausgegebenen Ausgangssignalen symmetrisierte, zueinander inverse beziehungsweise komplementäre Signale gegeben, die rein beispielhaft zur Ansteuerung von CMOS-Transistoren dienen können.

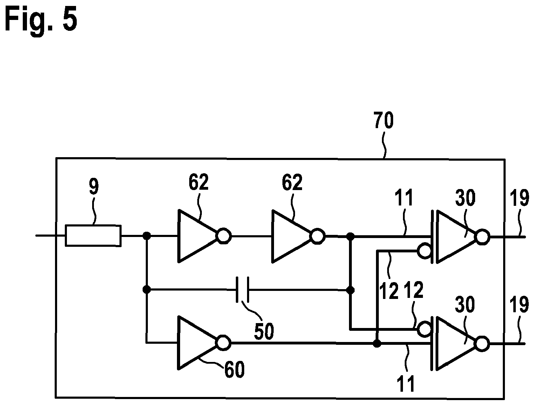

Die Figur 5 zeigt ein spezielles Ausführungsbeispiel eines erfindungsgemäßen logischen Gattersystems 70. Das in Figur 5 gezeigte Ausführungsbeispiel eines erfindungsgemäßen Gattersystems 70 entspricht im Wesentlichen dem des in Figur 4 gezeigten, weist jedoch im Unterschied zu diesem eingangsseitig eine weitere Beschaltung auf. Die gleich bezeichneten Komponenten in Figur 5 entsprechen jenen des Ausführungsbeispiels der Figur 4, sodass das dort Beschriebene bezüglich dieser Komponenten auch auf das Ausführungsbeispiel der Figur 5 zu übertragen ist.

Das in Figur 5 dargestellte Ausführungsbeispiel umfasst ein optionales Nicht-Gatter 60, dessen Ausgang mit dem invertierenden Eingang 12 des ersten logischen Gatters 30 und dem nicht-invertierenden Eingang 11 des zweiten logischen Gatters 30 verbunden ist. Ferner umfasst das Ausführungsbeispiel der Figur 5 rein beispielhaft ein optionales erstes und ein optionales zweites weiteres Nicht-Gatter 62. Der Eingang des ersten weiteren Nicht-Gatters 62 ist mit dem Eingang des Nicht-Gatters 60 elektrisch leitend verbunden. Der Ausgang des ersten weiteren Nicht-Gatters 62 ist elektrisch leitend mit dem Eingang des zweiten weiteren Nicht-Gatters 62 verbunden. Der Ausgang des zweiten weiteren Nicht-Gatters 62 ist wiederum elektrisch leitend mit dem nicht-invertierenden Eingang 11 des ersten logischen Gatters 30 verbunden. In diesem Ausführungsbeispiel ist der Eingang des ersten weiteren Nicht-Gatters 62 mit einem Eingang einer optionalen Eingangs-Schutzeinheit 9 verbunden, welche dazu ausgebildet ist, das logische Gattersystem 70 vor einer elektrostatischen Aufladung zu schützen. Die Eingangs-Schutzeinheit 9 weist in diesem Ausführungsbeispiel ferner einen weiteren Eingang auf, über welchen sie mit einer anderen Komponente, rein beispielhaft mit einer Treiberschaltung oder einem anderen logischen Gatter verbindbar ist.

Des Weiteren weist das in Figur 5 dargestellte Ausführungsbeispiel einen Kondensator 50 zur Kompensation von Schaltflanken-Überschwingern auf. Rein beispielhaft ist die elektrische Verbindung zwischen dem nicht-invertierenden Eingang 11 des ersten logischen Gatters 30 und dem invertierenden Eingang 12 des zweiten logischen Gatters 30 mit der ersten Elektrode des Kondensators 50 verbunden. Die zweite Elektrode des Kondensators 50 ist in diesem Ausführungsbeispiel rein beispielhaft mit der elektrischen Verbindung zwischen dem Eingang des ersten weiteren Nicht-Gatters 62 und dem Eingang des Nicht-Gatters 60 verbunden. Mit anderen Worten ausgedrückt, ist die zweite Elektrode 50 des Kondensators mit dem Eingang der Eingangs-Schutzeinheit 9, mit welchem auch der Eingang des ersten weiteren Nicht-Gatters 62 verbunden ist, verbunden.

In allen vorhergehenden Ausführungsbeispielen von erfindungsgemäßen logischen Gattersystemen 70 kann die Verschaltung des nicht-invertierenden Eingangs 11 und des invertierenden Eingangs 12 eines ersten logischen Gatters 30 mit dem nicht-invertierenden Eingang 11 beziehungsweise dem invertierenden Eingang 12 eines zweiten logischen Gatters 30 auch auf andere Art erfolgen und von der in den vorhergehenden Ausführungsbeispielen dargestellten Art abweichen. Ferner kann ein erfindungsgemäßes logisches Gattersystem 70 auch mehr oder weniger als zwei weitere Nicht-Gatter 62 beziehungsweise mehr als ein oder aber auch gar kein Nicht-Gatter 60 aufweisen. Auch können solche Nicht-Gatter 60 beziehungsweise weitere Nicht-Gatter 62 an anderen Positionen als denen in den hier gezeigten Ausführungsbeispielen innerhalb eines erfindungsgemäßen logischen Gattersystems 70 angeordnet sein. Ferner können auch gar kein oder mehr als ein Kondensator 50 zur Kompensation vor Schaltflanken-Überschwingern und auch mehr als eine oder gar keine Eingangs-Schutzeinheit 9 verbaut sein.

## Patentansprüche

1. Logisches Gatter (30) zur Symmetrierung mindestens zweier Eingangssignale, umfassend
- einen nicht-invertierenden Eingang (11),
- einen invertierenden Eingang (12),
- einen Ausgang (19),
wobei der am Ausgang (19) anliegende Wert dem Inversen des am invertierenden Eingang (12) anliegenden Wertes entspricht, wobei der Ausgang (19) ausschließlich dann aktiviert wird, wenn der am nicht-invertierenden Eingang (11) anliegende Wert ebenfalls dem Inversen des am invertierenden Eingang (12) anliegenden Wertes entspricht, wobei der Ausgang (19) in einem nicht aktivierten Zustand einen hochohmigen, nicht leitenden Zustand annimmt und in einem aktivierten Zustand der am Ausgang (19) anliegende Ausgangswert von den an dem nicht-invertierenden Eingang (11) und an dem invertierenden Eingang (12) anliegenden Werten der Eingangssignale abhängt und wobei das logische Gatter (30) ein UND-Gatter (4) mit einem invertierenden und einem nicht-invertierenden Eingang und ein ODER-Gatter (2) mit einem invertierenden und einem nicht invertierenden Eingang aufweist, wobei die nicht-invertierenden Eingänge von UND-Gatter (4) und ODER-Gatter (2) mit dem invertierenden Eingang (12) des logischen Gatters (30) verbunden sind, während die invertierenden Eingänge von UND-Gatter (4) und ODER-Gatter (2) mit dem nicht-invertierenden Eingang (11) des logischen Gatters (30) verbunden sind, wobei das UND-Gatter (4) sowie das ODER-Gatter (2) durch jeweils zwei zueinander komplementäre Transistoren realisiert sind, **dadurch gekennzeichnet, dass**
die Gate-Anschlüsse der das UND-Gatter (4) bildenden Transistoren miteinander zu dem invertierenden Eingang des UND-Gatters (4) verbunden sind und wobei die Gate-Anschlüsse der das ODER-Gatter (2) bildenden Transistoren miteinander zu dem invertierenden Eingang des ODER-Gatters (2) verbunden sind.

2. Logisches Gatter (30) nach Anspruch 1, wobei der Ausgang des UND-Gatters (4) mit der Steuerelektrode eines ersten Transistors (8) und der Ausgang des ODER-Gatters (2) mit der Steuerelektrode eines zweiten Transistors (6) verbunden ist.

3. Logisches Gatter (30) nach Anspruch 2, wobei die Schaltstrecke des ersten Transistors (8) mit der Schaltstrecke des zweiten Transistors (6) in Reihe geschaltet ist.

4. Logisches Gatter (30) nach Anspruch 3, wobei die elektrische Verbindung zwischen der Schaltstrecke des ersten Transistors (8) und der Schaltstrecke des zweiten Transistors (6) mit dem Ausgang (19) des logischen Gatters (30) elektrisch verbunden ist.

5. Logisches Gatter (30) nach einem der Ansprüche 2 bis 4, wobei der zweite Transistor (6) als P-Kanal-MOSFET und der erste Transistor (8) als N-Kanal-MOSFET ausgeführt sind.

6. Logisches Gattersystem (70), umfassend,
mindestens zwei logische Gatter (30), jeweils nach einem der vorhergehenden Ansprüche, wobei der nicht-invertierende Eingang (11) des zweiten logischen Gatters (30) mit dem invertierenden Eingang (12) des ersten logischen Gatters (30) verbunden ist, während der invertierende Eingang (12) des zweiten logischen Gatters (30) mit dem nicht-invertierenden Eingang (11) des ersten logischen Gatters (30) verbunden ist.

7. Logisches Gattersystem (70) nach Anspruch 6, ferner umfassend ein Nicht-Gatter (60), wobei der Eingang des Nicht-Gatters (60) mit dem nicht-invertierenden Eingang (11) des ersten logischen Gatters (30) verbunden ist, während der Ausgang des Nicht-Gatters (60) mit dem nicht-invertierenden Eingang (11) des zweiten logischen Gatters (30) verbunden ist.

8. Logisches Gattersystem (70) nach Anspruch 6, ferner umfassend ein Nicht-Gatter (60), wobei der Eingang des Nicht-Gatters (60) mit dem invertierenden Eingang (12) des ersten logischen Gatters (30) verbunden ist, während der Ausgang des Nicht-Gatters (60) mit dem invertierenden Eingang (12) des zweiten logischen Gatters (30) verbunden ist.

9. Logisches Gattersystem (70) nach Anspruch 7, ferner umfassend ein erstes und ein zweites weiteres Nicht-Gatter (62), welche in die elektrische Verbindung zwischen dem nicht-invertierenden Eingang (11) des ersten logischen Gatters (30) und dem Eingang des Nicht-Gatters (60) geschaltet sind, wobei der Ausgang des ersten weiteren Nicht-Gatters (62) mit dem Eingang des zweiten weiteren Nicht-Gatters (62) verbunden ist, wobei der Ausgang des zweiten weiteren Nicht-Gatters (62) mit dem nicht-invertierenden Eingang (11) des ersten logischen Gatters (30) verbunden ist, während der Eingang des ersten weiteren Nicht-Gatters (62) mit dem Eingang des Nicht-Gatters (60) verbunden ist.

10. Logisches Gattersystem (70) nach Anspruch 9, wobei der Eingang des ersten weiteren Nicht-Gatters (62) mit einer Eingangs-Schutzeinheit (9) verbunden ist, welche dazu ausgebildet ist, das logische Gattersystem (70) vor einer elektrostatischen Aufladung zu schützen.

11. Logisches Gattersystem (70) nach Anspruch 10, wobei die elektrische Verbindung zwischen dem nicht-invertierenden Eingang (11) des ersten logischen Gatters (30) und dem invertierenden Eingang (12) des zweiten logischen Gatters (30) mit der ersten Elektrode eines Kondensators (50) verbunden ist, dessen zweite Elektrode mit der elektrischen Verbindung zwischen dem Eingang des ersten weiteren Nicht-Gatters (62) und dem Eingang des Nicht-Gatters (60) verbunden ist.

## Claims

1. Logic gate (30) for balancing at least two input signals, comprising
- a non-inverting input (11),
- an inverting input (12),
- an output (19),
wherein the value applied to the output (19) corresponds to the inverse of the value applied to the inverting input (12), wherein the output (19) is activated only when the value applied to the non-inverting input (11) likewise corresponds to the inverse of the value applied to the inverting input (12), wherein the output (19) assumes a high-impedance, non-conductive state in a non-activated state and, in an activated state, the output value applied to the output (19) depends on the values of the input signals applied to the non-inverting input (11) and to the inverting input (12), and wherein the logic gate (30) has an AND gate (4) having an inverting input and a non-inverting input and an OR gate (2) having an inverting input and a non-inverting input, wherein the non-inverting inputs of the AND gate (4) and of the OR gate (2) are connected to the inverting input (12) of the logic gate (30), whereas the inverting inputs of the AND gate (4) and of the OR gate (2) are connected to the non-inverting input (11) of the logic gate (30),
wherein the AND gate (4) and the OR gate (2) are implemented by means of in each case two transistors which are complementary to one another, **characterized in that** the gate connections of the transistors forming the AND gate (4) are connected to one another to form the inverting input of the AND gate (4), and wherein the gate connections of the transistors forming the OR gate (2) are connected to one another to form the inverting input of the OR gate (2).

2. Logic gate (30) according to Claim 1, wherein the output of the AND gate (4) is connected to the control electrode of a first transistor (8) and the output of the OR gate (2) is connected to the control electrode of a second transistor (6).

3. Logic gate (30) according to Claim 2, wherein the switching path of the first transistor (8) is connected in series with the switching path of the second transistor (6).

4. Logic gate (30) according to Claim 3, wherein the electrical connection between the switching path of the first transistor (8) and the switching path of the second transistor (6) is electrically connected to the output (19) of the logic gate (30).

5. Logic gate (30) according to one of Claims 2 to 4, wherein the second transistor (6) is in the form of a P-channel MOSFET and the first transistor (8) is in the form of an N-channel MOSFET.

6. Logic gate system (70) comprising
at least two logic gates (30) each according to one of the preceding claims, wherein the non-inverting input (11) of the second logic gate (30) is connected to the inverting input (12) of the first logic unit (30), whereas the inverting input (12) of the second logic gate (30) is connected to the non-inverting input (11) of the first logic gate (30).

7. Logic gate system (70) according to Claim 6, also comprising a NOT gate (60), wherein the input of the NOT gate (60) is connected to the non-inverting input (11) of the first logic gate (30), whereas the output of the NOT gate (60) is connected to the non-inverting input (11) of the second logic gate (30).

8. Logic gate system (70) according to Claim 6, also comprising a NOT gate (60), wherein the input of the NOT gate (60) is connected to the inverting input (12) of the first logic gate (30), whereas the output of the NOT gate (60) is connected to the inverting input (12) of the second logic gate (30).

9. Logic gate system (70) according to Claim 7, also comprising a first and a second further NOT gate (62) which are connected into the electrical connection between the non-inverting input (11) of the first logic gate (30) and the input of the NOT gate (60), wherein the output of the first further NOT gate (62) is connected to the input of the second further NOT gate (62), wherein the output of the second further NOT gate (62) is connected to the non-inverted input (11) of the first logic gate (30), whereas the input of the first further NOT gate (62) is connected to the input of the NOT gate (60) .

10. Logic gate system (70) according to Claim 9, wherein the input of the first further NOT gate (62) is connected to an input protection unit (9) which is designed to protect the logic gate system (70) from electrostatic charging.

11. Logic gate system (70) according to Claim 10, wherein the electrical connection between the non-inverting input (11) of the first logic gate (30) and the inverting input (12) of the second logic gate (30) is connected to the first electrode of a capacitor (50), the second electrode of which is connected to the electrical connection between the input of the first further NOT gate (62) and the input of the NOT gate (60).

## Revendications

1. Porte logique (30) pour rendre symétriques au moins deux signaux d'entrée, comprenant
- une entrée non inverseuse (11),
- une entrée inverseuse (12),
- une sortie (19),
dans laquelle la valeur présente à la sortie (19) correspond à l'inverse de la valeur présente à l'entrée inverseuse (12), dans laquelle la sortie (19) est activée exclusivement lorsque la valeur présente à l'entrée non inverseuse (11) correspond également à l'inverse de la valeur présente à l'entrée inverseuse (12), dans laquelle la sortie (19) prend dans un état non activé un état non conducteur à haute résistance et dans un état activé la valeur de sortie présente à la sortie (19) dépend des valeurs des signaux d'entrée présentes à l'entrée non inverseuse (11) et à l'entrée inverseuse (12) et dans laquelle la porte logique (30) présente une porte ET (4) avec une entrée inverseuse et une entrée non inverseuse et une porte OU (2) avec une entrée inverseuse et une entrée non inverseuse, dans laquelle les entrées non inverseuses de la porte ET (4) et de la porte OU (2) sont reliées à l'entrée inverseuse (12) de la porte logique (30), tandis que les entrées inverseuses de la porte ET (4) et de la porte OU (2) sont reliées à l'entrée non inverseuse (11) de la porte logique (30), dans laquelle la porte ET (4) ainsi que la porte OU (2) sont chacune réalisées par deux transistors complémentaires l'un à l'autre, **caractérisée en ce que** les connexions de grille des transistors formant la porte ET (4) sont reliées l'une à l'autre pour former l'entrée inverseuse de la porte ET (4) et dans laquelle les connexions de grille des transistors formant la porte OU (2) sont reliées l'une à l'autre pour former l'entrée inverseuse de la porte OU (2).

2. Porte logique (30) selon la revendication 1, dans laquelle la sortie de la porte ET (4) est reliée à l'électrode de commande d'un premier transistor (8) et la sortie de la porte OU (2) est reliée à l'électrode de commande d'un second transistor (6).

3. Porte logique (30) selon la revendication 2, dans laquelle le trajet de commutation du premier transistor (8) est connecté en série avec le trajet de commutation du second transistor (6).

4. Porte logique (30) selon la revendication 3, dans laquelle la liaison électrique entre le trajet de commutation du premier transistor (8) et le trajet de commutation du second transistor (6) est électriquement reliée à la sortie (19) de la porte logique (30).

5. Porte logique (30) selon l'une quelconque des revendications 2 à 4, dans laquelle le second transistor (6) est formé par un MOSFET Canal P et le premier transistor (8) est formé par un MOSFET Canal N.

6. Système de portes logiques (70), comprenant au moins deux portes logiques (30), chacune selon l'une quelconque des revendications précédentes, dans lequel l'entrée non inverseuse (11) de la seconde porte logique (30) est reliée à l'entrée inverseuse (12) de la première porte logique (30), tandis que l'entrée inverseuse (12) de la seconde porte logique (30) est reliée à l'entrée non inverseuse (11) de la première porte logique (30).

7. Système de portes logiques (70) selon la revendication 6, comprenant en outre une porte NON (60), dans lequel l'entrée de la porte NON (60) est reliée à l'entrée non inverseuse (11) de la première porte logique (30), tandis que la sortie de la porte NON (60) est reliée à l'entrée non inverseuse (11) de la seconde porte logique (30).

8. Système de portes logiques (70) selon la revendication 6, comprenant en outre une porte NON (60), dans lequel l'entrée de la porte NON (60) est reliée à l'entrée inverseuse (12) de la première porte logique (30), tandis que la sortie de la porte NON (60) est reliée à l'entrée inverseuse (12) de la seconde porte logique (30) .

9. Système de portes logiques (70) selon la revendication 7, comprenant en outre une première et une seconde portes NON supplémentaires (62), qui sont connectées dans la liaison électrique entre l'entrée non inverseuse (11) de la première porte logique (30) et l'entrée de la porte NON (60), dans lequel la sortie de la première porte NON supplémentaire (62) est reliée à l'entrée de la seconde porte NON supplémentaire (62), dans lequel la sortie de la seconde porte NON supplémentaire (62) est reliée à l'entrée non inverseuse (11) de la première porte logique (30), tandis que l'entrée de la première porte NON supplémentaire (62) est reliée à l'entrée de la porte NON (60).

10. Système de portes logiques (70) selon la revendication 9, dans lequel l'entrée de la première porte NON supplémentaire (62) est reliée à une unité de protection d'entrée (9), qui est configurée pour protéger le système de portes logiques (70) contre une surcharge électrostatique.

11. Système de portes logiques (70) selon la revendication 10, dans lequel la liaison électrique entre l'entrée non inverseuse (11) de la première porte logique (30) et l'entrée inverseuse (12) de la seconde porte logique (30) est reliée à la première électrode d'un condensateur (50), dont la seconde électrode est reliée à la liaison électrique entre l'entrée de la première porte NON supplémentaire (62) et l'entrée de la porte NON (60) .
